# EUROPÄISCHE PATENTSCHRIFT

(11) **EP 4 275 264 B1**
(45) Veröffentlichungstag und Bekanntmachung des Hinweises auf die Patenterteilung: **29.01.2025**
(21) Anmeldenummer: 21824557.9
(22) Anmeldetag: 03.12.2021
(51) Int. Cl.: H02K 9/197, H02K 3/24, H02K 7/18, H02K 1/20, H02K 9/19, H02K 5/128

(54) **STATOR**
STATOR
STATOR

(30) Priorität: 05.01.2021 EP 21150248
(43) Veröffentlichungstag der Anmeldung: 15.11.2023
(73) Patentinhaber: Flender GmbH, 46395 Bocholt (DE)
(72) Erfinder: WINKLER, Günther, 4785 Freinberg (AT)
(74) Vertreter: Michalski Hüttermann & Partner Patentanwälte mbB
(86) Internationale Anmeldenummer: PCT/EP2021/084120
(87) Internationale Veröffentlichungsnummer: WO 2022/148578

(56) Entgegenhaltungen:
- CN-A- 101 752 915
- DE-A1- 102012 203 502
- JP-U- S5 110 502
- US-A- 3 675 056
- US-A1- 2013 193 786
- US-A1- 2016 190 878
- US-A1- 2018 138 784
- US-B2- 8 629 585
- US-B2- 9 419 499

## Beschreibung

Die Erfindung betrifft einen Stator für einen elektromechanischen Wandler, insbesondere für eine dynamoelektrische Maschine, ausgebildet für das Zusammenwirken mit einem Rotor, umfassend
- ein Kühlsystem,
- ein Wicklungssystem,
- einen Kern, umfassend mindestens einen magnetisch leitfähigen Körper,
wobei der Stator sich entlang einer Längsachse erstreckt, wobei der Kern Ausnehmungen aufweist, in denen Wicklungsstränge des Wicklungssystems zumindest teilweise angeordnet sind, und wobei das Kühlsystem für die Durchströmung mittels eines Kühlmediums eingerichtet ist.

Elektromechanische Wandler sind Elektromotoren oder Generatoren, insbesondere dynamoelektrische Maschinen.

Der Stator eines elektromechanischen Wandlers, insbesondere das Wicklungssystem muss aufgrund der Verluste, zum Beispiel Eisenverluste (Kern), Leiterverluste usw., gekühlt werden. Für eine effiziente Entwärmung reicht meist eine Luftkühlung nicht mehr aus, so dass eine Flüssigkeitskühlung, insbesondere Wasserkühlung oder Ölkühlung, vorgesehen wird. In dem Kern sind in der Regel dafür Kühlkanäle des Kühlsystems in dem magnetisch leitfähigen Körper der z.B. dynamoelektrischen Maschine, vorgesehen.

Die DE 24 62 150 oder die EP 0 684 682 B1 zeigen elektromechanische Wandler mit entsprechenden Kühlkanälen in einem Blechschnitt des Kerns. Elektromechanische Wandler mit Kühlungen sind ferner auch aus US 3 675 056 A, US 8 629 585 B2 und DE 10 2012 203 502 A1 bekannt.

Herkömmliche Statoren weisen im Betrieb häufig eine nicht einheitliche Entwärmung auf. Regelmäßig ergeben sich beispielsweise an Wickelköpfen des Wicklungssystems erhöhte Temperaturen im Vergleich zu den übrigen Komponenten. Daneben ist auch die sonstige Temperaturverteilung häufig inhomogen. Dieses Phänomen ist auch in der Regel dadurch verursacht, dass sich bei der Durchströmung des Kühlsystems mit dem Kühlmedium Strähnen unterschiedlicher Temperaturen ausprägen und dass die Durchströmung des Kühlsystems derart ungleichmäßig erfolgt, dass größere Mengen des Kühlmediums durch bestimmte Regionen des Kühlsystems strömen und in anderen Regionen des Kühlsystems mit weniger Durchströmung (zB. strömungstechnische Totwassergebiete) sich dadurch vergleichsweise höhere Temperaturen ausbilden. Thermische Unausgeglichenheit entsteht auch dadurch, dass nicht an allen Stellen des Stators eine identische Abwärmeleistung entsteht.

Diese Ungleichmäßigkeit im Kühlsystem überträgt sich als ungleichmäßige Temperaturverteilung auf den Kern, sodass Werkstoffeigenschaften in manchen Regionen des Kerns früher ausgeschöpft sind infolge der höheren thermischen Belastung, als in anderen Regionen.

Aus US 2013/193786 A1 ist ein elektromechanischer Wandler bekannt, aufweisend einen Stator mit einem Blechpaket, wobei in dem Blechpaket mehrere sich axial erstreckende, parallele Kühlkanäle zwischen Wicklungen angeordnet sind. In axialer Richtung mittig des Blechpakets ist eine Zuströmung zu den Kühlkanälen mit einer Verteilung ausgebildet, so dass die Kühlkanäle von der Zuströmung zu äußeren Enden durchströmt werden. An den äußeren Enden weist jeder Kühlkanal eine Öffnung auf, wobei die Öffnung, insbesondere hinsichtlich der Schwerkraft, derart auf die Position des jeweiligen Kühlkanals in dem Stator angepasst ist, dass in allen Kühlkanälen ein gleichmäßiger Durchfluss erreicht wird. Nachteilig ist der aus US 2013/193786 A1 bekannte elektromechanische Wandler aufwändig.

Aus JP S51 10502 U ist zudem ein elektromechanischer Wandler bekannt, bei dem ein Kühlmedium aus einer Öffnung auf den Rotor aufgebracht wird und zudem dem Stator axial durchströmt und in einem axial mittig angeordneten Spalt des Stators zusammengeführt wird.

Aus US 2018/138784 A1, US 9 419 499 B2 und CN 101 752 915 A sind weiterhin elektromechanische Wandler mit Kühlungen bekannt, bei denen Düsen zum Besprühen und somit gezielten Kühlen von Wickelköpfe vorgesehen sind.

Ausgehend von den Problemen und Nachteilen des Standes der Technik hatte sich die Erfindung zur Aufgabe gemacht, die Entwärmung des Kerns zu verbessern.

Zur Lösung der Aufgabe, schlägt die Erfindung einen Stator gemäß dem unabhängigen Anspruch 1 vor. Im Einzelnen ist vorgesehen, dass das Kühlsystem mindestens eine Düse aufweist, die im Betrieb von dem Kühlmedium durchströmt wird, so dass das Kühlmedium stromabwärts der Düse als beschleunigter Strahl ausströmt, wobei die Düse derart ausgebildet und ausgerichtet ist, dass ein Teil des Wicklungssystems von dem beschleunigten Strahl aus der Düse getroffen wird, wobei der Kern mindestens zwei axial nebeneinander angeordnete Körper aufweist, einen ersten Körper und einen zweiten Körper, wobei der erste Körper um einen Axialspalt beabstandet von dem zweiten Körper angeordnet ist, und wobei das Kühlmedium in dem Axialspalt aus verschiedenen parallel geführten Strömungspfaden zusammengeführt wird.

Die Ausrichtung der Düse ist erfindungsgemäß derart, dass der beschleunigte Strahl mindestens hinsichtlich der axial-radialen Ausrichtung auf einen Wickelkopf des Wicklungssystems gerichtet ist. Die Erfindung hat hierbei unter anderem erkannt, dass für eine ausgeglichene Temperaturverteilung an den Stellen mit höherer Wärmeleistung fokussierter gekühlt werden muss. Gleichzeitig ermöglicht die Benutzung der erfindungsgemäßen Düsen neben einer gezielten Kühlung von Bereichen, die eine höhere Abwärmeleistung haben auch eine gezielte Verteilung des Kühlmittels, derart, dass eine ansonsten gleichmäßige Kühlung für eine einheitliche Temperaturverteilung gegeben ist.

Weiterhin vorteilhaft hat die Erfindung erkannt, das mittels einer Zusammenführung in dem Axialspalt zwischen zwei Körpern des Kerns eine besonders günstige Kühlmittelführung ermöglichst wird, bei der das Kühlmittel von den axialen Enden des Kerns, an denen die Wickelköpfe angeordnet sind, nach innen geführt wird. Das Kühlmittel wird demnach nach dem Aufsprühen auf die Wickelköpfe, an denen die höchsten Temperaturen im System auftreten, erfindungsgemäß an den Wickelköpfen abgeführt und entlang der Wicklungen durch den Stator geführt. Insbesondere ist so eine Kühlmittelführung geschaffen, bei der das Kühlmittel in einem regenerierten Zustand, also mit möglichst geringer Temperatur, zunächst auf die Wickelköpfe trifft und dort besonders effizient die entstehende Wärme abführen kann. Anschließend werden dann die restlichen Wicklungen und der Kern durchströmt und dabei gekühlt.

Sofern nicht anders angegeben, beziehen sich vorliegend Begriffe, wie radial, tangential, axial oder Umfangsrichtung auf eine Längsachse des Stators.

Ein Aspekt der Erfindung sieht vor, dass das Kühlsystem eine Zusammenführung von parallel zueinander geführten Strömungspfaden, insbesondere aller parallel zueinander geführten Strömungspfade, stromabwärts der jeweiligen Aufteilung vorsieht. Die Aufteilungen und Zusammenführungen können jeweils kaskadiert ausgebildet sein. Die Parallelführung von Strömungspfaden ermöglicht eine zielgenauere Kühlung der einzelnen wärmeproduzierenden Komponenten. Grundsätzlich versteht die Erfindung unter dem in diesem Zusammenhang benutzten Begriff "parallel" nicht die geometrische parallele Anordnung, sondern lediglich eine Aufteilung von einer zunächst gemeinsamen Strömung in zwei Strömungspfade und eine anschließende Wiedervereinigung bzw. Zusammenführung. Diese Aufteilung und Wiedervereinigung bzw. die Parallelführung kann hierbei auch derart erfolgen, dass ein aus einer Aufteilung resultierender Strömungspfad nochmals geteilt wird und stromabwärts entweder alle zugleich zusammengeführt werden oder nacheinander. Nach einem weiteren Aspekt der Erfindung ist vorgesehen, dass der Kern mehrerer Körper aufweist und das Kühlsystem vorsieht, dass eine Aufteilung der Strömung des Kühlmediums auf die einzelnen Körper erfolgt und anschließend diese Aufteilung wiedervereinigt wird. In den Körpern selbst kann eine weitere Aufteilung der Strömungsführung erfolgen.

Bevorzugt sind der Körper oder die Körper des Kerns als Blechpakete ausgebildet.

Für die Trennung der beiden Körper mittels des Axialspalts kann es zweckmäßig sein, dass Abstandhalter zwischen den Körpern vorgesehen sind, die eine axiale Annäherung der Körper verhindern.

Eine gute Kombination von einer Kühlung des Wicklungssystems und der Kühlung der Körper des Kerns ergibt sich, wenn zumindest einige sich axial durch den Kern erstreckende Wicklungsstränge gemeinsam mit angrenzenden Oberflächen der jeweiligen Ausnehmungen in den Körpern die parallel durchströmten Kanäle des Kühlsystems in dem Körper definieren, so dass das Kühlmedium an dem jeweiligen Wicklungsstrang entlang strömt. Hierbei kann das Wicklungssystem zwischen einem Leiter des Wicklungssystems und einer Wandung der Ausnehmung, in der ein Wicklungsstrang angeordnet ist, eine Isolierung bzw. Hauptisolierung aufweisen. Zwischen der Hauptisolierung und der Wandung kann zweckmäßig ein Kühlkanal bzw. Kanal des Kühlsystems vorgesehen sein. Hierbei ist es sinnvoll, wenn die Hauptisolierung und/oder das Wicklungssystem selbst bzw. ein Wicklungsstrang eine den Kanal zumindest teilweise bildende Vertiefung in Längsrichtung des Kanals aufweist, wobei die Ausbuchtung als eine Prägung in der Isolierung und/oder dem Leitermaterial ausgebildet sein kann.

Bevorzugt ist der jeweilige Wicklungsstrang als Teil einer Formspule ausgebildet und derart gewickelt, dass sich eine Grundform ergibt, die bereits Anteile eines Kühlkanals aufweist. Alternativ dazu und besonders bevorzugt wird zunächst ein Wicklungsstrang als Teil einer Formspule ohne Ausbildung eines Kühlkanals hergestellt und anschließend mit einer Isolierung bzw. Hauptisolierung versehen, die mindestens eine bevorzugt nachträglich eingebrachte Einprägung aufweist, sodass die Einprägung gemeinsam mit einer Nutwandung oder Ausnehmungswandung des jeweiligen Körpers einen Kühlkanal-Abschnitt ergibt. Die Einprägung erstreckt sich bevorzugt in der axialen Richtung länger als die Ausnehmung, in der der Wicklungsstrang liegt, so dass an Enden der Ausnehmung ein Zufluss und/oder ein Abfluss aus dem Kanal ausgebildet wird. Der Wicklungsstrang kann aus Leiterstäben und/oder Windungen und/oder elektrisch parallel geschalteten Teilleitern bestehen.

Besonders zweckmäßig weist der Stator in dem Bereich, der im betriebsfertigen Zustand an einen Rotor grenzt, ein Spaltrohr auf, das den Stator von dem Rotor - bevorzugt hermetisch - trennt, sodass das Kühlsystem des Stators unabhängig von dem Rotor betrieben werden kann bzw. das Kühlsystem des Stators gegenüber dem Rotor geschlossen ist.

Bei einer Aufspaltung des Kerns in mindestens zwei axial voneinander beabstandete Körper ist es zweckmäßig, wenn die Wicklungsstränge sich axial durch den Kern - den Axialspalt überbrückend - erstrecken.

Der Axialspalt kann zweckmäßig durch Abstandhalter gewährleistet werden.

Eine vorteilhafte Weiterbildung der Erfindung sieht vor, dass axial neben dem Kern auf einer ersten Seite ein erster Sammelraum stromaufwärts des Kerns für das Kühlmedium vorgesehen ist. Alternativ oder zusätzlich kann axial neben dem Kern auf einer zweiten Seite ein zweiter Sammelraum stromaufwärts des Kerns für das Kühlmedium vorgesehen sein. Bei der Variante mit zwei Sammelräumen ist eine Aufspaltung bzw. Aufteilung der Kühlmediumströme in dem Kühlsystem vor den beiden Sammelräumen zweckmäßig. In anderen Worten: das Kühlsystem weist dann eine zweiflutige Ausführung auf, wobei die beiden Strömungspfade der zwei Fluten jeweils einen Sammelraum aufweisen, von dem jeweils besonders bevorzugt eine Aufteilung in zueinander parallele Strömungsführungen des Kühlmediums bevorzugt durch jeweils einen anderen Körper des Kerns erfolgt.

Eine vorteilhafte Weiterbildung der Erfindung sieht vor, dass das Wicklungssystem Wickelköpfe aufweist, wobei mindestens ein Wickelkopf in einem Sammelraum zumindest teilweise angeordnet ist, wobei die mindestens eine Düse derart ausgerichtet ist, dass der beschleunigte Strahl mindestens hinsichtlich der axial-radialen Ausrichtung auf einen Wickelkopf gerichtet ist. Die Ausrichtung der bevorzugt mehreren Düsen kann rein radial sein oder schräg zur radialen und axialen Richtung. Besonders bevorzugt sind die Düsen radial außenliegend zu den Wickelköpfen angeordnet und der beschleunigte Strahl ist parallel zur radialen Richtung von außen nach innen auf den mindestens einen Wickelkopf gerichtet. Bei mehreren Düsen können diese derart ausgerichtet und angeordnet sein, dass die einzelnen Strahlen bezüglich einer jeweiligen Strahlmittelachse entweder in einer gedachten ringförmigen Verbindung in Umfangsrichtung miteinander im Wesentlichen eine radiale Ebene definieren oder eine Konusform.

Eine vorteilhafte Weiterbildung der Erfindung sieht vor, dass das Kühlsystem jeweils an der Einmündung in den Sammelraum einen sich entlang der Umfangsrichtung über mindestens einen Teil des Umfangs sich erstreckenden Zulaufkanal aufweist, der Ausströmöffnungen aus dem Zulaufkanal in den Sammelraum aufweist. Hierbei sind bevorzugt die Ausströmöffnungen derart ausgebildet, dass das Kühlmedium gleichmäßig über den Umfang verteilt in den Sammelraum einströmt. Bevorzugt erstreckt sich der Zulaufkanal jeweils über den gesamten Umfang. Es können alle Ausströmöffnungen als Düsen in einer Wandung des Zulaufkanals ausgebildet sein, insbesondere derart, dass die Wandung als gelochtes Blech ausgebildet ist. Alternativ ist nur ein Teil der Ausströmöffnungen sind Düsen ausgebildet, so dass die anderen Ausströmöffnungen bevorzugt der ansonsten möglichst gleichmäßigen Verteilung dienen.

Die Ausströmöffnungen können an unterschiedlichen Umfangspositionen und/oder Radialpositionen vorgesehen sein können, und/oder die Ausströmöffnungen können zumindest teilweise unterschiedlich groß sein und/oder unterschiedlich beabstandet angeordnet sein, und/oder die Ausströmöffnungen können bevorzugt derart ausgebildet sein, dass die Umfangsverteilung der Kühlmedium-Durchströmung auf die Ausströmöffnungen während des Nennbetriebes im Wesentlichen einer Ziel-Umfangsverteilung entspricht. Die Ziel-Umfangsverteilung kann bevorzugt eine einheitliche Verteilung über den Umfang vorsehen, so dass keine Anteile des Stators überhitzen. Hier ist es besonders bevorzugt, wenn zumindest einige der Ausströmöffnungen als besagte Düsen ausgebildet sind, in die das Kühlmedium einströmt und auf einen Teil des Wicklungssystems als beschleunigter Strahl gerichtet ausströmt.

Eine vorteilhafte Weiterbildung der Erfindung sieht vor, dass das Kühlsystem derart ausgebildet ist, dass stromaufwärts - der an beiden Axialseiten des Kerns angeordneten Sammelräume - eine erste Aufteilung in mindestens zwei parallel zueinander geführte Strömungspfade vorgesehen ist und die Sammelräume sich in den parallel geführten Strömungspfaden befinden.

Insbesondere, wenn ein hochwertiges Kühlmedium benutzt wird, ist es zweckmäßig, wenn das Kühlmedium entlang eines geschlossenen Kreislaufs geführt wird. Bevorzugt gibt es einen primären Kreislauf des Kühlsystems, der geschlossen ausgebildet ist. Dieser kann mittels eines Wärmetauschers von einer anderen Wärmesenke gekühlt werden, z.B. mittels einer Luftkühlung (sekundäre Kühlung).

Besonders vorteilhaft ist das Kühlsystem derart mit dem Kühlmedium gefüllt, dass während des Betriebs in dem Kühlsystem gegenüber der Umgebung ein Unterdruck von mindestens 0,1 bar, bevorzugt 0,3 bar herrscht. Hierzu kann eine entsprechende Druckregelung des Kühlsystems vorgesehen sein, die derart ausgebildet ist, dass während des Betriebs in dem Kühlsystem gegenüber der Umgebung ein Unterdruck von mindestens 0,1 bar, bevorzugt 0,3 bar herrscht. Bevorzugt weist das Kühlsystem eine Pumpe auf, die besonders bevorzugt einen Förderdruck von mindestens Δp=0,3 bar, bevorzugt zwischen Δp=0,4bar bis 0,6 bar (z.B. Δp=0,5 bar) aufweist. Ein Unterdruck in dem Stator wirkt sich positiv auf die Stabilität eines Spaltrohrs aus, da die Zylinderform des Spaltrohrs bei einem höheren Innendruck gegenüber dem Außendruck mechanisch stabiler ist als bei umgekehrten Druckverhältnissen. Dementsprechend kann das Spaltrohr bei einer derartigen Betriebsweise mit einer geringeren Wandstärke ausgebildet sein, sodass sich positive Effekte für den Wirkungsgrad des elektromechanischen Wandlers ergeben. In einem Normalbetrieb des Kühlsystems ist zu erwarten, dass sich über die Düsen bzw. Ausströmöffnungen jeweils eine Druckdifferenz von etwa 0,1 bar einstellen kann. Die Durchströmung des Kerns entlang von dort vorgesehenen Kühlkanälen - insbesondere z.B. zwischen den Wicklungssträngen und den magnetisch leitfähigen Körpern - kann in etwa eine Druckdifferenz von 0,3 bar erzeugen.

Elektromechanische Wandler nach der Erfindung werden bevorzugt bei Windkraftanlagen in der Bauform eines Generators eingesetzt, da sie bei kompakter Bauweise eine hohe Leistungsdichte aufweisen.

Ein bevorzugtes Anwendungsfeld der Erfindung sind daher Generatoren, insbesondere mit Permanentmagnet- Rotoren, insbesondere von Windkraftanlagen, sodass sich die Erfindung auch auf Generatoren oder auf Generatoren von Windkraftanlagen oder auf eine Windkraftanlage mit einem Generator umfassend ein Stator nach der Erfindung bezieht. Ein anderes Anwendungsgebiet der Erfindung sind Asynchronmaschinen, insbesondere Käfigläufermotoren. Bei Asynchronmaschinen muss aufgrund der geringeren Luftspalte im Vergleich zu den Permanentmagnet-Rotoren das Spaltrohr relativ dünnwandig ausgeführt werden.

Hierbei oder außerdem kann ein computerimplementiertes Verfahren zur Simulation des Betriebs eines Stators gemäß der Erfindung benutzt werden. Insbesondere ist es zweckmäßig, wenn der Entwurf eines Stators bzw. einer entsprechenden Gesamtmaschine (elektromechanischer Wandler) mittels des computerimplementierten Verfahrens simuliert wird. Auf diese Weise ist es möglich, die bestmögliche Konfiguration variabler Designparameter und Betriebsparameter herauszufinden unter Berücksichtigung der sich während der Simulation unter verschiedenen Betriebsbedingungen ergebenden Temperaturverteilung im Kern. Darüber hinaus ist die Möglichkeit der Simulation auch wertvoll, betriebsbegleitend Aussagen über die Temperaturverteilung und mögliche Grenzwertüberschreitungen bzw. Materialbeschädigungen machen zu können und gegebenenfalls zu entscheiden, welches Betriebsszenario tatsächlich umgesetzt werden soll. Simulation kann betriebsbegleitend unterstützen, Wartungsintervalle festzulegen, Lebensdauervorhersagen zu machen und Ersatzteile vorzusehen. In diesem Zusammenhang, wenn es zwischen der Simulation - also dem virtuellen Abbild des Stators - und der physikalischen Verkörperung eine Verbindung mit einem Sensor gibt, wird gegenwärtig auch häufig von einem digitalen Zwilling gesprochen.

Eine vorteilhafte Ausgestaltung der Erfindung ist in der Folge anhand eines prinzipiell dargestellten Ausführungsbeispiels näher erläutert. Es zeigen:
- Figur 1: eine schematische Darstellung eines elektromechanischen Wandlers in einem radial halbierten Längsschnitt umfassend Details des Kühlsystems,
- Figur 2: eine schematische Darstellung eines elektromechanischen Wandlers in einem Längsschnitt,
- Figur 3: den Schnitt III-III ausgewiesen in Figur 2,
- Figur 4: perspektivisch schematische Detailansicht von Wicklungssträngen in Nuten des Körpers,
- Figur 5: eine schematische Darstellung einer auf einem Computer ablaufenden Simulation.

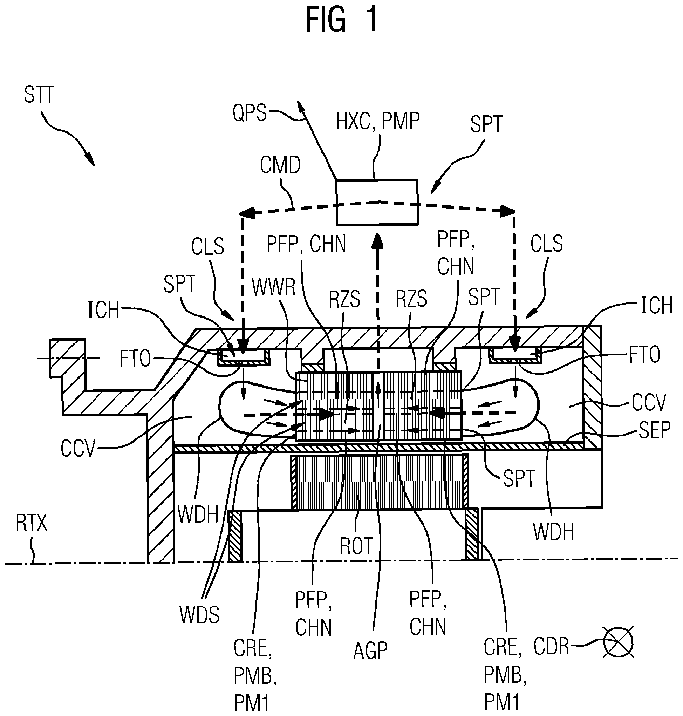

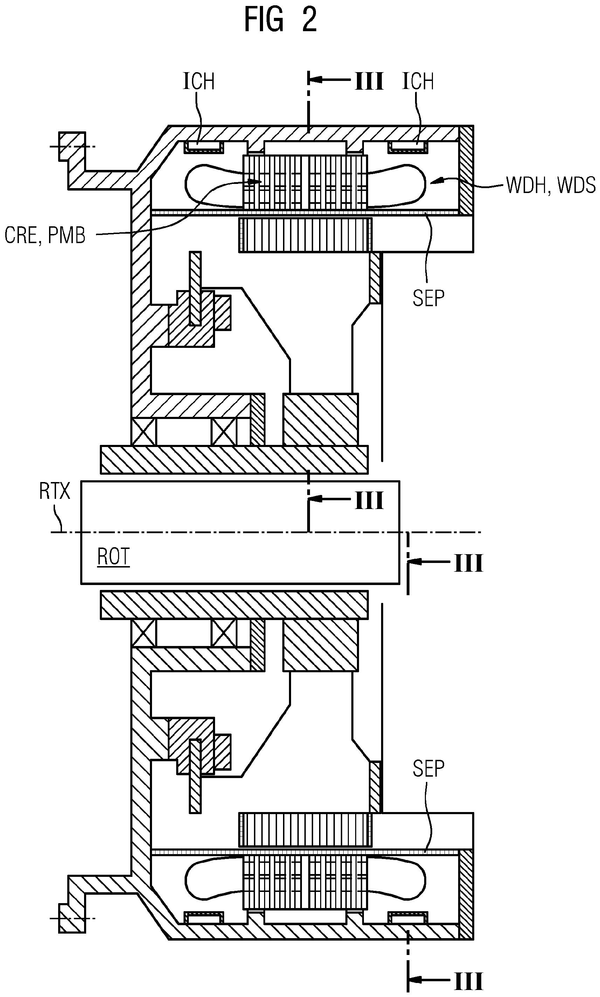

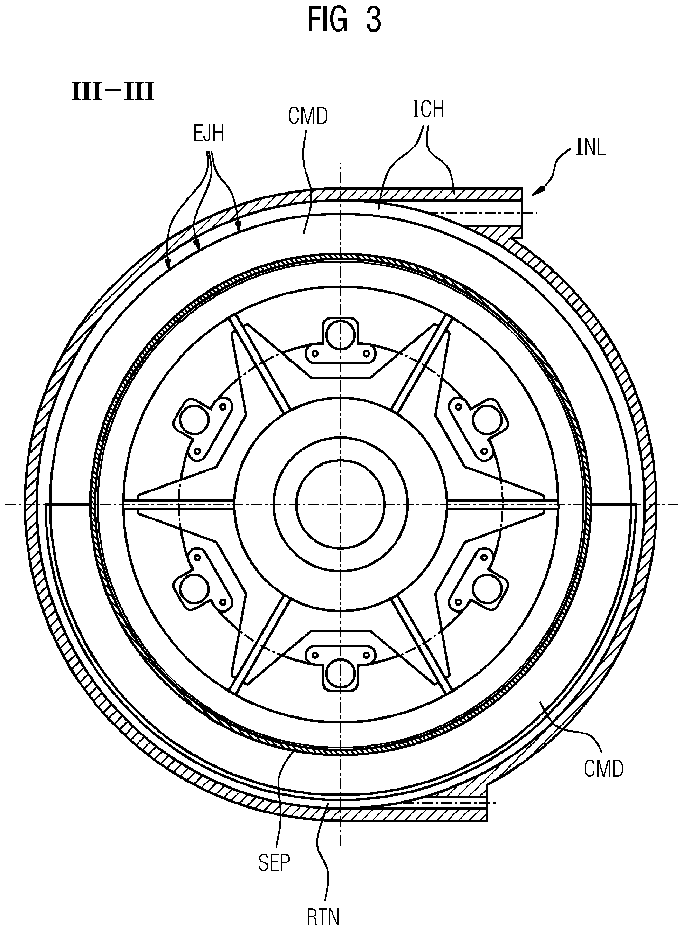

Figur 1 zeigt in einer radial halbierten schematischen Längsschnittdarstellung einen als dynamoelektrische Maschine ausgeführten elektromechanischen Wandler - hier einen Generator - wobei der Schwerpunkt der Darstellung auf einem Stator STT liegt, der im Wesentlichen zylindrisch in Umfangsrichtung CDR und entlang einer Längsrichtung einer Längsachse RTX einen Rotor ROT umgibt. Die Figur 2 zeigt ebenfalls - hier in gesamter radialer Darstellung - einen Längsschnitt. Figur 3 zeigt den Schnitt III-III ausgewiesen in Figur 2.

Der um die Längsachse RTX rotierbar gelagerte Rotor ROT ist in der Darstellung nur angedeutet. Der für das Zusammenwirken mit dem Rotor ROT ausgebildete Stator STT umfasst ein Kühlsystem CLS, ein Wicklungsystem WDS und einen Kern CRE.

Das Kühlsystem CLS wird von einem Kühlmedium CMD durchströmt.

Das Kühlsystem CLS erstreckt sich hierbei ausgehend von einem Wärmetauscher HXC zunächst von einer ersten Aufteilung SPT des Kühlmediums CMD ausgehend zweiflutig zu jeweils einem axialen Ende des Stators STT, wo das Kühlmedium CMD an den axialen Enden des Stators STT jeweils in einen Sammelraum CCV eintritt.

Die beiden Körper PMB des Kerns CRE weisen in Längsrichtung angeordnete Kanäle CHN entlang der Wicklungsstränge WWR auf. Das Kühlmedium CMD durchströmt dementsprechend die Körper PMB zumindest abschnittsweise in axialer Richtung. Stromabwärts der Durchströmung der beiden Körper PMB werden die beiden parallel geführten Strömungspfade PFP wieder zusammengeführt.

Das Wicklungsystem WDS umfasst eine Isolierung ISO. Der Kern CRE umfasst zwei magnetisch leitfähige Körper PMB, einen ersten Körper PM1 und einen zweiten Körper PM2, die axial voneinander beanstandet sind. Zwischen den beiden Körpern PM1, PM2 befindet sich ein Axialspalt AGP. Wicklungsstränge WWR des Wicklungsystem WDS sind zumindest teilweise in Ausnehmungen RZS des Kerns CRE angeordnet (näheres ist hierzu auch der Figur 3 entnehmbar). Die Wicklungsstränge WWR erstrecken sich durch die Körper PMB des Kerns CRE den Axialspalt AGP überbrückend.

Die Zusammenführung der parallelen Strömungspfade PFP des Kühlmediums CMD erfolgt in dem Axialspalt AGP, wobei stromabwärts des Axialspalts AGP das Kühlmedium CMD wieder dem Wärmetauscher HXC zugeführt wird. Der Wärmetauscher HXC führt die Verlustleistung QPS einer nicht dargestellten Wärmesenke zu. Diese kann zum Beispiel eine sekundäre Luftkühlung sein. Daneben umfasst der Wärmetauscher HXC auch geeignete Mittel, das Kühlmedium CMD in einem geschlossenen Kreislauf zu befördern (in der Regel wird hier eine Pumpe eingesetzt, da das Kühlmedium CMD bei den anstehenden zu entwärmenden Leistungen in der flüssigen Phase eingesetzt ist) - es sei denn, es ist ein ausreichender Naturumlauf gewährleistet. Vorliegend ist eine Pumpe PMP in dem Wärmetauscher HXC integriert, die einen Förderdruck von mindestens 0,3 bar, bevorzugt zwischen 0,4bar - 0,6 bar (z.B. Δp=0,5 bar) aufweist. Das Kühlsystem CLS ist derart mit dem Kühlmedium gefüllt, dass während des Betriebs in dem Kühlsystem gegenüber der Umgebung ein Unterdruck von ca. 0,3 bar herrscht. Hierzu kann eine entsprechende Druckregelung (vorliegend Bestandteil des Wärmetauschers HXC) des Kühlsystems CLS vorgesehen sein, die derart ausgebildet ist, dass während des Betriebs in dem Kühlsystem gegenüber der Umgebung ein Unterdruck von mindestens 0,1 bar, bevorzugt 0,3 bar herrscht. Der Unterdruck in dem Stator gegenüber dem Atmosphärendruck wirkt sich positiv auf die Stabilität des Spaltrohrs SEP aus, da die Zylinderform des Spaltrohrs SEP bei einem höheren Innendruck gegenüber dem Außendruck mechanisch stabiler ist.

Das Kühlsystem CLS weist Düsen FTO auf, die im Betrieb von dem Kühlmedium CMD durchströmt werden, so dass das Kühlmedium CMD stromabwärts der Düse FTO als beschleunigter Strahl ausströmt. Vorliegend sind diese Düsen FTO als Ausströmöffnungen EJH aus einem Zulaufkanal ICH in den Sammelraum CCV auf beiden axialen Seiten ausgebildet. Der Zulaufkanal ICH erstreckt sich jeweils entlang der Umfangsrichtung CDR an einer Innenseite einer radialen Außenwand des auf den beiden axialen Seiten befindlichen Sammelraums CCV. Hierbei sind die die Ausströmöffnungen EJH in einer Wandung des Zulaufkanals ICH ausgebildet, insbesondere derart, dass die Wandung als gelochtes Blech ausgebildet. Diese Anordnung sorgt dafür, dass das Kühlmedium CMD gleichmäßig über den Umfang verteilt in den Sammelraum einströmt. Die Ausströmöffnungen EJH sind als besagte Düsen FTO ausgebildet, in die das Kühlmedium CMD einströmt und auf die Wicklungsköpfe WDH als beschleunigter Strahl gerichtet ausströmt.

Die Vereinigung aller parallel geführten Strömungspfade PFP erfolgt in dem Axialspalt AGP.

Der Figur 3 gezeigte Querschnitt III - III weist einen Versatz in der Mitte auf und zeigt sowohl die Zuführung INL des Kühlmediums CMD über den Zulaufkanal ICH durch die Ausströmöffnungen EJH in den Sammelraum CCV als auch (in dem unteren Bereich der Darstellung) die Rückführung RTN des Kühlmediums CMD zu dem Wärmetauscher HXC.

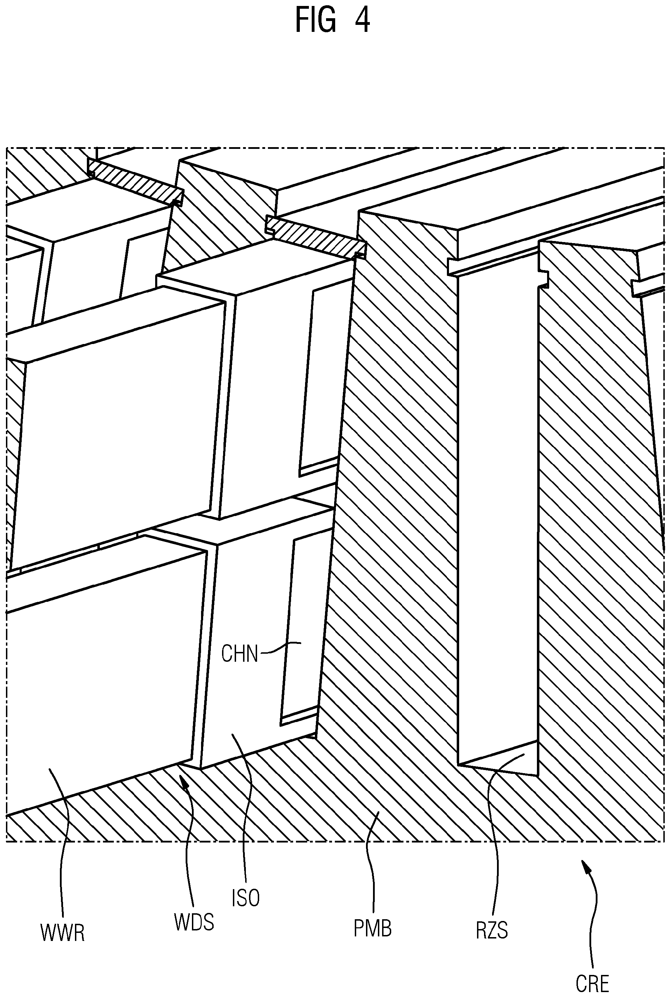

Die Figur 4 zeigt eine perspektivisch schematische Detailansicht von Wicklungssträngen WWR angeordnet in als Nuten ausgebildeten Ausnehmungen RZS des Körpers PMB. Die Wicklungsstränge WWR sind mit einer Isolierung ISO versehen, wobei im Wesentlichen parallel zueinander verlaufende Kanäle CHN zur Durchströmung mittels des Kühlmediums CMD des Kühlsystems CRS als Einprägungen in der Isolierung ISO vorgesehen sind. Auf diese Weise verlaufen die Kanäle CHN in axialer Längsrichtung entlang der Wicklungsstränge WWR und entlang einer Oberflächen der Körper PMB, sodass eine einheitliche Entwärmung des Kerns CRE gewährleistet ist. Das Kühlmedium CMD kühlt sowohl die Körper PMB als auch die einzelnen Wicklungsstränge WWR dadurch, dass die axial durch den Kern CRE sich erstreckenden Wicklungsstränge WWR gemeinsam mit angrenzenden Oberflächen der jeweiligen Ausnehmungen RZS in den Körpern PMB die parallel durchströmten Kanäle CHN des Kühlsystems in dem Körpern PMB definieren, so dass das Kühlmedium CMD an dem jeweiligen Wicklungsstrang WWR und entlang der Körper PMB strömt.

In den von dem Kühlsystem CLS ausgehend betrachtet stromaufwärts der jeweiligen Durchströmung der Körper PMB angeordneten Sammelräumen findet nach der ersten in dem Beispiel in dem Wärmetauscher HXC vorgesehenen Aufteilung eine zweite Aufteilung SPT des Kühlmediums CMD in parallele Strömungspfade durch die jeweiligen Körper PM1, PM2 statt. Dementsprechend ist die Aufteilung in parallele Strömungspfade PFP quasi kaskadiert, sodass sich nach einer ersten Aufteilung SPT die Sammelräume CCV in parallel geführten Strömungspfaden CSP befinden und in den Sammelräumen CCV eine zweite Aufteilung SPT in parallel zu einander geführte Strömungspfade PFP entlang der Kanäle CHN in den Körper PMB erfolgt.

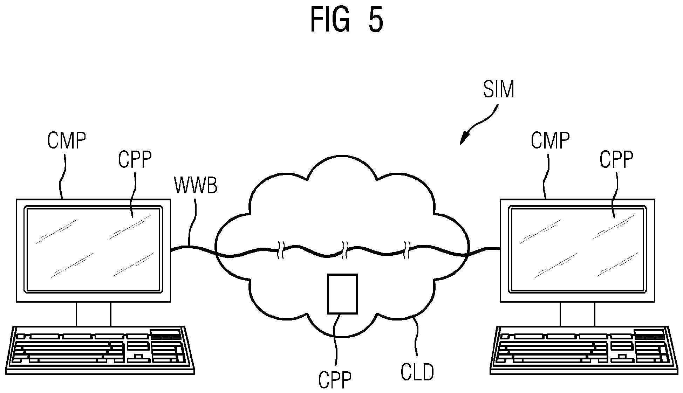

Figur 5 zeigt eine schematische Darstellung einer auf einem Computer CMP - hier auf mehreren Computern CMP eines Netzwerks WWB umfassend eine Cloud CLD - ablaufenden Simulation SIM.

Die auf den Computern CMP installierte Software ist ein Computer-Programmprodukt CPP, das bei Ausführung auf mindestens einem Computer CMP dem Benutzer mittels Schnittstellen Bildschirm, Tastatur eine Einflussnahme bzw. Konfiguration und einen Erkenntnisgewinn auf Basis der ausgeführten Simulation SIM ermöglicht, so dass insbesondere technische Gestaltungsentscheidungen mittels der Simulation unterstützt und verifiziert werden können.

Obwohl die Erfindung im Detail durch das bevorzugte Ausführungsbeispiel näher illustriert und beschrieben wurde, ist die Erfindung nicht durch die offenbarten Beispiele eingeschränkt. Variationen hiervon können vom Fachmann abgeleitet werden, ohne den Schutzumfang der Erfindung, wie er durch die nachfolgenden Patentansprüche definiert wird, zu verlassen.

## Patentansprüche

1. Stator (STT) für einen elektromechanischen Wandler, insbesondere für eine dynamoelektrische Maschine, ausgebildet für das Zusammenwirken mit einem Rotor (ROT), umfassend
- ein Kühlsystem (CLS),
- ein Wicklungssystem (WDS),
- einen Kern (CRE), umfassend mindestens einen magnetisch leitfähigen Körper (PMB),
wobei der Stator (STT) sich entlang einer Längsachse (RTX) erstreckt,
wobei der Kern (CRE) Ausnehmungen (RZS) aufweist, in denen Wicklungsstränge (WWR) des Wicklungssystems (WDS) zumindest teilweise angeordnet sind,
wobei das Kühlsystem (CLS) für die Durchströmung mittels eines Kühlmediums (CMD) eingerichtet ist,
wobei das Kühlsystem mindestens eine Düse (FTO) aufweist, die im Betrieb von dem Kühlmedium (CMD) durchströmt wird, so dass das Kühlmedium (CMD) stromabwärts der Düse (FTO) als beschleunigter Strahl ausströmt, wobei die Düse (FTO) derart ausgebildet und auf einen Wickelkopf (WDH) des Wicklungssystems (WDS) gerichtet ist, dass ein Teil des Wicklungssystems (WDS) von dem beschleunigten Strahl aus der Düse getroffen wird,
wobei das Kühlmedium (CMD)an dem Wickelkopf (WDH) abgeführt und entlang der Wicklungsstränge (WWR) durch die Ausnehmungen (RZS) geführt wird,
wobei der Kern (CRE) mindestens zwei axial nebeneinander angeordnete Körper (PM1, PM2) aufweist, einen ersten Körper (PM1) und einen zweiten Körper (PM2),
wobei der erste Körper (PM1) um einen Axialspalt (AGP) beabstandet von dem zweiten Körper (PMB) angeordnet ist,
und wobei das Kühlmedium (CMD) in dem Axialspalt (AGP) aus verschiedenen parallel geführten Strömungspfaden (PFP) zusammengeführt wird.

2. Stator (STT) nach Anspruch 1, wobei das Kühlsystem (CLS) derart ausgebildet ist, dass das Kühlmedium (CMD) entlang eines geschlossenen Kreislaufs geführt wird.

3. Stator (STT) nach einem der vorhergehenden Ansprüche,
wobei axial neben dem Kern (CRE) auf einer ersten Seite ein erster Sammelraum (CCV) stromaufwärts des Kerns (CRE) für das Kühlmedium (CMD) vorgesehen ist und/oder
wobei axial neben dem Kern (CRE) auf einer zweiten Seite ein zweiter Sammelraum (CCV) stromaufwärts des Kerns (CRE) für das Kühlmedium (CMD) vorgesehen ist.

4. Stator (STT) nach Anspruch 3, wobei der Wickelkopf (WDH) in einem Sammelraum (CCV) zumindest teilweise angeordnet ist, wobei die mindestens eine Düse (FTO) derart ausgerichtet ist, dass der beschleunigte Strahl hinsichtlich der axial-radialen Ausrichtung auf den Wickelkopf (WDH) gerichtet ist.

5. Stator (STT) nach mindestens einem der vorhergehenden Ansprüche 3, 4, wobei das Kühlsystem (CLS) auf beiden axialen Seiten einen Sammelraum (CCV) aufweist, derart, dass jeweils stromaufwärts der Sammelräume (CCV) eine erste Aufteilung (SPT) in mindestens zwei parallel zueinander geführte Strömungspfade (PFP) des Kühlmediums vorgesehen ist und die Sammelräume (CCV) und die auf Wickelköpfe (WDH) gerichteten Düsen (FTO) sich in den parallel geführten Strömungspfaden (PFP) befinden.

6. Stator (STT) nach mindestens einem der vorhergehenden Ansprüche 3, 4, 5, wobei das Kühlsystem (CLS) jeweils an der Einmündung in den Sammelraum (CCV) einen sich entlang der Umfangsrichtung (CDR) über mindestens einen Teil des Umfangs sich erstreckenden Zulaufkanal (ICH) aufweist, der Ausströmöffnungen (EJH) aus dem Zulaufkanal (ICH) in den Sammelraum (CCV) aufweist, wobei die Ausströmöffnungen (EJH) derart ausgebildet sind, dass das Kühlmedium (CMD) gleichmäßig über den Umfang verteilt in den Sammelraum einströmt.

7. Stator (STT) nach mindestens dem vorhergehenden Anspruch 6, wobei zumindest einige der Ausströmöffnungen (EJH) als besagte Düsen (FTO) ausgebildet sind, in die das Kühlmedium (CMD) einströmt und auf einen Teil des Wicklungssystems (WDS) als beschleunigter Strahl gerichtet ausströmt.

8. Stator (STT) nach mindestens dem der vorhergehenden Anspruch 6, wobei der Zulaufkanal (ICH) sich jeweils über den gesamten Umfang erstreckt.

9. Stator (STT) nach dem vorhergehenden Anspruch 8, wobei alle Ausströmöffnungen (EJH) als Düsen (FTO) in einer Wandung des Zulaufkanals (ICH) ausgebildet sind, insbesondere derart, dass die Wandung als gelochtes Blech ausgebildet ist.

10. Stator (STT) nach dem vorhergehenden Anspruch 9, wobei das Kühlsystem (CLS) in dem Körper (PMB) angeordnete Kanäle (CHN) aufweist, die derart ausgebildet sind, dass das Kühlmedium (CMD) den Körper (PMB) zumindest abschnittsweise in axialer Richtung durchströmt,
wobei das Kühlsystem (CLS) derart ausgebildet ist, dass das Kühlmedium (CMD) auf mindestens zwei parallel zueinander geführte Strömungspfade (PFP) entlang des Kerns (CRE) aufgeteilt wird.

11. Stator (STT) nach einem der vorhergehenden Ansprüche, wobei zumindest einige sich axial durch den Kern (CRE) erstreckende Wicklungsstränge gemeinsam mit angrenzenden Oberflächen der jeweiligen Ausnehmungen (RZS) die parallel durchströmten Kanäle (CHN) des Kühlsystems in dem Körper (PMB) definieren, so dass das Kühlmedium (CMD) an dem jeweiligen Wicklungsstrang (WWR) entlang strömt.

12. Stator (STT) nach einem der vorhergehenden Ansprüche, wobei das Kühlsystem derart mit dem Kühlmedium gefüllt ist, dass während des Betriebs in dem Kühlsystem gegenüber der Umgebung ein Unterdruck von mindestens 0,1 bar, bevorzugt 0,3 bar herrscht.

## Claims

1. Stator (STT) for an electromechanical converter, in particular for a dynamo-electric machine, configured for interaction with a rotor (ROT), comprising:
- a cooling system (CLS),
- a winding system (WDS),
- a core (CRE), comprising at least one magnetically conductive body (PMB),
wherein the stator (STT) extends along a longitudinal axis (RTX),
wherein the core (CRE) has recesses (RZS), in which winding strands (WWR) of the winding system (WDS) are arranged at least partially,
wherein the cooling system (CLS) is configured for throughflow by means of a cooling medium (CMD),
wherein the cooling system has at least one nozzle (FTO) which is flowed through by the cooling medium (CMD) during operation, with the result that the cooling medium (CMD) flows out downstream of the nozzle (FTO) as an accelerated jet, wherein the nozzle (FTO) is configured and directed onto a winding head (WDH) of the winding system (WDS) in such a way that a part of the winding system (WDS) is impinged on by the accelerated jet from the nozzle,
wherein the cooling medium (CMD) is discharged at the winding head (WDH) and is conducted along the winding strands (WWR) through the recesses (RZS),
wherein the core (CRE) has at least two bodies (PM1, PM2) which are arranged axially next to one another, a first body (PM1) and a second body (PM2),
wherein the first body (PM1) is arranged spaced apart by an axial gap (AGP) from the second body (PMB),
and wherein the cooling medium (CMD) is combined in the axial gap (AGP) from different flow paths (PFP) which are routed in parallel.

2. Stator (STT) according to Claim 1, wherein the cooling system (CLS) is configured in such a way that the cooling medium (CMD) is conducted along a closed circuit.

3. Stator (STT) according to either of the preceding claims, wherein a first collection space (CCV) is provided upstream of the core (CRE) for the cooling medium (CMD) axially next to the core (CRE) on a first side, and/or
wherein a second collection space (CCV) is provided upstream of the core (CRE) for the cooling medium (CMD) axially next to the core (CRE) on a second side.

4. Stator (STT) according to Claim 3, wherein the winding head (WDH) is arranged at least partially in a collection space (CCV), wherein the at least one nozzle (FTO) is oriented in such a way that the accelerated jet is directed with regard to the axial-radial orientation onto the winding head (WDH).

5. Stator (STT) according to at least one of the preceding Claims 3 and 4, wherein the cooling system (CLS) has a collection space (CCV) on the two axial sides, in such a way that a first division (SPT) into at least two flow paths (PFP) of the cooling medium which are routed parallel to one another is provided in each case upstream of the collection spaces (CCV), and the collection spaces (CCV) and the nozzles (FTO) which are directed onto winding heads (WDH) are situated in the flow paths (PFP) which are routed in parallel.

6. Stator (STT) according to at least one of the preceding Claims **3,** 4 and **5,** wherein the cooling system (CLS) has, in each case at the opening into the collection space (CCV), a feed channel (ICH) which extends along the circumferential direction (CDR) over at least a part of the circumference and has outflow openings (EJH) from the feed channel (ICH) into the collection space (CCV), wherein the outflow openings (EJH) are configured in such a way that the cooling medium (CMD) flows into the collection space in a manner which is distributed homogeneously over the circumference.

7. Stator (STT) according to at least the preceding Claim **6,** wherein at least some of the outflow openings (EJH) are configured as the said nozzles (FTO), into which the cooling medium (CMD) flows and out of which it flows in a manner which is directed as an accelerated jet onto a part of the winding system (WDS).

8. Stator (STT) according to at least the preceding Claim **6,** wherein the feed channel (ICH) extends in each case over the entire circumference.

9. Stator (STT) according to the preceding Claim **8,** wherein all the outflow openings (EJH) are configured as nozzles (FTO) in a wall of the feed channel (ICH), in particular in such a way that the wall is configured as a perforated metal sheet.

10. Stator (STT) according to the preceding Claim **9,** wherein the cooling system (CLS) has channels (CHN) which are arranged in the body (PMB) and are configured in such a way that the cooling medium (CMD) flows through the body (PMB) at least in portions in the axial direction, wherein the cooling system (CLS) is configured in such a way that the cooling medium (CMD) is divided into at least two flow paths (PFP), routed parallel to one another, along the core (CRE).

11. Stator (STT) according to one of the preceding claims, wherein at least some winding strands which extend axially through the core (CRE) define, together with adjoining surfaces of the respective recesses (RZS), the channels (CHN) of the cooling system in the body (PMB) which are flowed through in parallel, with the result that the cooling medium (CMD) flows along the respective winding strand (WWR).

12. Stator (STT) according to one of the preceding claims, wherein the cooling system is filled with the cooling medium in such a way that, during operation, a negative pressure in comparison with the surroundings of at least **0.1** bar, preferably 0.3 bar prevails in the cooling system.

## Revendications

1. Stator (STT) pour un transducteur électromécanique, notamment pour une machine dynamoélectrique, configuré pour coopérer avec un rotor (ROT), comprenant
- un système de refroidissement (CLS),
- un système d'enroulement (WDS),
- un noyau (CRE), comprenant au moins un corps magnétiquement conducteur (PMB),
le stator (STT) s'étendant le long d'un axe longitudinal (RTX),
le noyau (CRE) présentant des évidements (RZS) dans lesquels sont agencés au moins partiellement des brins d'enroulement (WWR) du système d'enroulement (WDS),
le système de refroidissement (CLS) étant conçu pour être traversé au moyen d'un fluide de refroidissement (CMD),
le système de refroidissement présentant au moins une buse (FTO) qui, en fonctionnement, est traversée par le fluide de refroidissement (CMD), de telle sorte que le fluide de refroidissement (CMD) sort en aval de la buse (FTO) sous forme de jet accéléré, la buse (FTO) étant configurée et dirigée vers une tête d'enroulement (WDH) du système **d'enroulement** (WDS) de telle sorte qu'une partie du système d'enroulement (WDS) est touchée par le jet accéléré provenant de la buse,
le fluide de refroidissement (CMD) étant évacué au niveau de la tête d'enroulement (WDH) et guidé le long des brins d'enroulement (WWR) à travers les évidements (RZS),
le noyau (CRE) présentant au moins deux corps (PM1, PM2) agencés axialement l'un à côté de l'autre, un premier corps (PM1) et un deuxième corps (PM2),
le premier corps (PM1) étant agencé à distance du deuxième corps (PMB) d'un interstice axial (AGP),
et le fluide de refroidissement (CMD) étant réuni dans l'interstice axial (AGP) à partir de différentes voies d'écoulement (PFP) guidées en parallèle.

2. Stator (STT) selon la revendication 1, le système de refroidissement (CLS) étant configuré de telle sorte que le fluide de refroidissement (CMD) est guidé le long d'un circuit fermé.

3. Stator (STT) selon l'une quelconque des revendications précédentes, un premier espace de collecte (CCV) étant prévu axialement à côté du noyau (CRE) sur un premier côté en amont du noyau (CRE) pour le fluide de refroidissement (CMD) et/ou
un deuxième espace de collecte (CCV) étant prévu axialement à côté du noyau (CRE) sur un deuxième côté en amont du noyau (CRE) pour le fluide de refroidissement (CMD) .

4. Stator (STT) selon la revendication 3, la tête d'enroulement (WDH) étant au moins partiellement agencée dans un espace de collecte (CCV), l'au moins une buse (FTO) étant orientée de telle sorte que le jet accéléré soit dirigé vers la tête d'enroulement (WDH) en ce qui concerne l'orientation radiale axiale.

5. Stator (STT) selon au moins l'une quelconque des revendications 3, 4 précédentes, le système de refroidissement (CLS) présentant des deux côtés axiaux un espace de collecte (CCV), de telle sorte qu'une première répartition (SPT) en au moins deux voies d'écoulement (PFP) guidées en parallèle l'une de l'autre du fluide de refroidissement est prévue en amont des espaces de collecte (CCV) et les espaces de collecte (CCV) et les buses (FTO) dirigées vers les têtes d'enroulement (WDH) se trouvent dans les voies d'écoulement (PFP) guidées en parallèle.

6. Stator (STT) selon au moins l'une quelconque des revendications 3, 4, 5 précédentes, le système de refroidissement (CLS) présentant respectivement à l'embouchure de l'espace de collecte (CCV) un canal d'alimentation (ICH) s'étendant le long de la direction circonférentielle (CDR) sur au moins une partie de la circonférence, qui présente des ouvertures de sortie (EJH) du canal d'alimentation (ICH) dans l'espace de collecte (CCV), les ouvertures de sortie (EJH) étant configurées de telle sorte que le fluide de refroidissement (CMD) pénètre dans l'espace de collecte en étant réparti uniformément sur la circonférence.

7. Stator (STT) selon au moins la revendication 6 précédente, au moins certaines des ouvertures de sortie (EJH) étant configurées sous la forme desdites buses (FTO) dans lesquelles le fluide de refroidissement (CMD) pénètre et sort sous forme de jet accéléré dirigé sur une partie du système d'enroulement (WDS).

8. Stator (STT) selon au moins la revendication 6 précédente, le canal d'alimentation (ICH) s'étendant respectivement sur toute la circonférence.

9. Stator (STT) selon la revendication 8 précédente, toutes les ouvertures de sortie (EJH) étant configurées sous forme de buses (FTO) dans une paroi du canal **d'alimentation** (ICH), notamment de telle sorte que la paroi est configurée sous forme de tôle perforée.

10. Stator (STT) selon la revendication **9,** le système de refroidissement (CLS) présentant des canaux (CHN) agencés dans le corps (PMB), qui sont configurés de telle sorte que le fluide de refroidissement (CMD) traverse le corps (PMB) au moins par sections dans la direction axiale,
le système de refroidissement (CLS) étant configuré de telle sorte que le fluide de refroidissement (CMD) est réparti sur au moins deux voies d'écoulement (PFP) guidées en parallèle l'une de l'autre le long du noyau (CRE) .

11. Stator (STT) selon l'une quelconque des revendications précédentes, au moins certains brins d'enroulement s'étendant axialement à travers le noyau (CRE) définissant, conjointement avec des surfaces adjacentes des évidements respectifs (RZS), les canaux traversés en parallèle (CHN) du système de refroidissement dans le corps (PMB), de telle sorte que le fluide de refroidissement (CMD) s'écoule le long du brin d'enroulement respectif (WWR).

12. Stator (STT) selon l'une quelconque des revendications précédentes, le système de refroidissement étant rempli avec le fluide de refroidissement de telle sorte que, pendant le fonctionnement, il existe dans le système de refroidissement une pression négative d'au moins 0,1 bar, de préférence de 0,3 bar, par rapport à l'environnement.
